# EUROPEAN PATENT SPECIFICATION

(11) **EP 1 964 174 B1**
(45) Date of publication and mention of the grant of the patent: **02.05.2012**
(21) Application number: 06842564.4
(22) Date of filing: 15.12.2006
(51) Int. Cl.: H01L 23/66, H01P 3/08, H01Q 15/00, H05K 1/02

(54) **ENHANCED SUBSTRATE USING METAMATERIALS**
VERSTÄRKTES SUBSTRAT MIT METAMATERIALIEN
SUBSTRAT AMÉLIORÉ UTILISANT DES MÉTAMATÉRIAUX

(30) Priority: 15.12.2005 US 751095 P
(43) Date of publication of application: 03.09.2008
(60) Divisional application: 10175620.3
(73) Proprietor: Taiwan Semiconductor Manufacturing Co., Ltd., Hsin-Chu, 300-77 (TW)
(72) Inventor: WYLAND, Chris, San Jose, California 95131 (US)
(74) Representative: Hutter, Jacobus Johannes
(86) International application number: PCT/IB2006/054899
(87) International publication number: WO 2007/069224

(56) References cited:
- WO-A-03/030298
- US-A1- 2005 212 625
- CHENG C-Y ET AL: "TAILORING DOUBLE-NEGATIVE METAMATERIAL RESPONSES TO ACHIEVE ANOMALOUS PROPAGATION EFFECTS ALONG MICROSTRIP TRANSMISSION LINES" IEEE TRANSACTIONS ON MICROWAVE THEORY AND TECHNIQUES, IEEE SERVICE CENTER, PISCATAWAY, NJ, US, vol. 51, no. 12, December 2003 (2003-12), pages 2306-2314, XP001046429 ISSN: 0018-9480
- SHELBY R A ET AL: "Microwave transmission through a two-dimensional, isotropic, left-handed metamaterial" APPLIED PHYSICS LETTERS, AIP, AMERICAN INSTITUTE OF PHYSICS, MELVILLE, NY, US, vol. 78, no. 4, 22 January 2001 (2001-01-22), pages 489-491, XP012028465 ISSN: 0003-6951
- ZIOLKOWSKI R W: "DESIGN, FABRICATIONS, AND TESTING OF DOUBLE NEGATIVE METAMATERIALS" IEEE TRANSACTIONS ON ANTENNAS AND PROPAGATION, IEEE SERVICE CENTER, PISCATAWAY, NJ, US, vol. 51, no. 7, July 2003 (2003-07), pages 1516-1529, XP001170047 ISSN: 0018-926X cited in the application
- GIL I ET AL: "Metamaterials in microstrip technology for filter applications" ANTENNAS AND PROPAGATION SOCIETY SYMPOSIUM, 2005. IEEE WASHINGTON, DC, JULY 3 - 8, 2005, PISCATAWAY, NJ : IEEE, US, 3 July 2005 (2005-07-03), pages 668-671Vol1A, XP010857957 ISBN: 0-7803-8883-6
- CHRIS WYLAND ED - XING WANG ET AL: "Use of negative permeability metamaterials to improve signal impedance" SIGNAL PROPAGATION ON INTERCONNECTS, 2006. IEEE WORKSHOP ON, IEEE, PI, May 2006 (2006-05), pages 287-289, XP031012740 ISBN: 1-4244-0454-1
- ZIOLKOWSKI R W: "Design, fabrication, and testing of double negative metamaterials", IEEE TRANSACTIONS ON ANTENNAS AND PROPAGATION, IEEE SERVICE CENTER, PISCATAWAY, NJ, US, vol. 51, no. 7, 1 July 2003 (2003-07-01), pages 1516-1529, XP011097626, ISSN: 0018-926X, DOI: DOI:10.1109/TAP.2003.813622
- CALOZ C ET AL: "A novel multilayer super-compact inharmonic photonic band-gap (PBG) structure for microstrip applications", MICROWAVE CONFERENCE, 2001. APMC 2001. 2001 ASIA-PACIFIC DECEMBER 3-6, 201, PISCATAWAY, NJ, USA,IEEE, PISCATAWAY, NJ, USA, 3 December 2001 (2001-12-03), pages 651-654vol.2, XP031437865, ISBN: 978-0-7803-7138-5

## Description

The invention relates to integrated circuit (IC) packaging. More particularly this invention relates to the use of meta-materials in a packaging substrate to reduce noise that may be present on a signal line.

The electronics industry continues to rely upon advances in semiconductor technology to realize higher-function devices in more compact areas. For many applications realizing higher-functioning devices requires integrating a large number of electronic devices into a single silicon wafer. As the number of electronic devices per given area of the silicon wafer increases, the manufacturing process becomes more difficult.

Many varieties of semiconductor devices have been manufactured with various applications in numerous disciplines. Such silicon-based semiconductor devices often include metal-oxide-semiconductor field-effect transistors (MOSFET), such as p-channel MOS (PMOS), n-channel MOS (NMOS) and complementary MOS (CMOS) transistors, bipolar transistors, BiCMOS transistors. Such MOSFET devices include an insulating material between a conductive gate and silicon-like substrate; therefore, these devices are generally referred to as IGFETs (insulated-gate FET).

Each of these semiconductor devices generally includes a semiconductor substrate on which a number of active devices are formed. The particular structure of a given active device can vary between device types. For example, in MOS transistors, an active device generally includes source and drain regions and a gate electrode that modulates current between the source and drain regions.

Furthermore, such devices may be digital or analog devices produced in a number of wafer fabrication processes, for example, CMOS, BiCMOS, Bipolar, etc. The substrates may be silicon, gallium arsenide (GaAs) or other substrate suitable for building microelectronic circuits thereon.

After undergoing the process of fabrication, the silicon wafer has a predetermined number of devices. These devices are tested. Good devices are collected and packaged.

As more performance and functionality is built into IC devices, the sending of signals internal to the IC and to other components on the ICs periphery becomes a challenge. When sending a signal from one chip to another, the signal must usually travel through a variety of interconnect such as a package, a printed circuit board and a socket. Generally, the impedance of signal lines through these entities differs from one another. The impedance mismatch causes noise on the line owing to reflections of energy at the impedance boundaries. Upon the inter-connect this energy initiates a resonant response. This resonance is typically at a different frequency and time than that of the signal and is interpreted as noise in the circuit.

A. F. Starr et al. write in their paper titled, "Fabrication and Characterization of a Negative-Refractive-Index Composite Meta-material," Physical Review B 70, 113102 (2004) of the American Physical Society, "while there have not been many suggested paths toward the design of a material whose effective index-of-refraction is negative, a rigorous approach is to design a material whose electric permittivity (ε) and magnetic permeability (µ) are simultaneously negative... While there are no known naturally occurring materials or compounds that exhibit simultaneously negative ε and µ, artificially structure materials can be designed whose effective s and µ, as derived from effective medium arguments, are both negative over a finite frequency band."

C. Calor et al., "A novel multilayer super-compact inharmonic photonic band-gap (PBg) structure for microstrip applications", Proc. of APMC, 2001, p.651-654, discloses a structure according to the features of the preamble of claim 1.

Cheng C-Y. et al, "Tailoring Double-Negative Metamaterial Responses to Achieve Anomalous Propagation Effects along Microstrip Transmission Lines". IEEE Transactions on Microwave Theory and Techniques. Vol. 51. No. 12. December 2003, pp. 2306-2314. discloses a structure of double-negative (DNG) materials, i.e., materials with both negative permittivity and negative permeability. This document discloses a study_of the performance of microstrip transmission lines loaded with DNG MTMs formed by embedding capacitively loaded strips and capacitivily loaded loops arranged in a substrate region. The transmission line is arranged on a top surface of the substrate and a ground plane is located on a bottom surface of the substrate. A metamaterial (MTM) structure is defined as having two such capacitively loaded strips in parallel and one capacitivily loaded loop in between. A plurality of MTMs is arranged in parallel between the transmission line and the ground plane, such that all the capacitively loaded strips and capacitivily loaded loops are arranged perpendicular to both the transmission line and the ground plane.

Shelby R.A. et al., "Microwave transmission through a tw-dimensional, isotropic, left-handed metamaterial", Applied Physics Letters, Vol. 78, No. 4, 2001, pp. 489-491, discloses a metamaterial exhibiting a left-handed electromagnetic-wave propagation in two spatial dimensions. The metamaterial is arranged as a lattice structure formed by unit cells. Each unit cell of the metamaterial comprises two orthogonal thin fiberglass boards, each board comprising three split-ring resonators (SRRs) on one side and one wire strip on the opposite side. Shelby does not disclose a signal line and a ground plane. Shelby also does not disclose that the SRRs and wire strips are embedded in the substrate.

Ziolkowski, "Design, Fabrication, and testing of double-negative metamaterials", IEEE Transactions on Antennas and Propagation, Vol. 51, No. 7, July 2003, pp. 151.6-1529, discloses the design, fabrication and testing of several double-negative metamaterials (MTMs) formed by embedding capacitively loaded strip (CLS) and split-ring resonators (SRRs) in a substrate region. The CLS and SRR unit cells are thereby directed transversely with respect to the top and bottom surfaces of the dielectric substrate.

Gil I. et al., "Metamaterials in Microstrip Technology for Filter Applications". Antennas and Propagation Society Symposium, 2005, IEEE. Washington DC, July 3-8. 2005, pp. 668-671, Vol 1A, discloses SRR-based left handed microstrip lines. However. D5 does not unambiguously disclose that the SRR structures as embedded in the substrate. Neither does D5 disclose where the ground plane is arranged_with respect to the SRR structures. Y et. amended claim 1 is delimited from D5 since figure 3A shown a layout of a fabricated LHM microstrip line comprising four SRR unit cells in an array along the transmission line.

Such a meta-material in which the permittivity and permeability of a packaging substrate could be influenced in a negative direction finds a potential role in high performance IC devices. Consequently, there is-exists a need to minimize noise at the impedance boundaries of an IC device in a cost-effective manner.

To that end, the present invention relates to a device as defined in claim 1.

This invention has been found useful in enhancing signal quality through packages by using meta-materials for the insulator of the substrate. Meta-materials are materials which are designed to make the signal act in such a way as to make the shape of the signal behave as though the permittivity and permeability are different than the real component permittivity and permeability of the insulator used. It should be noted that the relative permittivity and relative permeability include both real and imaginary components, that is ε_{R} = ε_{R} + Jε_{R} and µ_{R}=µ_{R} + jµ_{R} It is possible to design meta-materials so as to have the signal respond as if the permittivity and permeability have negative values. In this invention, an insulator material is designed to reduce the noise present from the resonant mode of the signal line. The meta-material is an arrangement of conductors in the insulator that reduces the resonant response of the line on the signal.

In an example embodiment, there is a substrate having a topside surface and an underside surface, the substrate configured as a meta-material, the meta-material providing noise protection for a signal line of pre-determined dimensions defined on the topside surface. The substrate comprises a conductive ground plane defining the underside surface of the substrate. A layer of a conductive material is configured into two concentric rectangles; each rectangle has a notch defined on a side about a midpoint and the notch in a first rectangle is opposite the notch in a second rectangle; the first rectangle has a smaller perimeter than the second rectangle. The layer of conductive material is disposed above the conductive ground plane at a first pre-determined distance and the layer of the conductive material is disposed at a second pre-determined distance below the signal line defined on the topside surface of the substrate. A dielectric material envelops the layer of the conductive material; the dielectric material is bounded between the topside surface and underside surface of the substrate. The collective dimensions of the two concentric rectangles are comparable to the pre-determined dimensions of the signal line. A feature of this embodiment includes, the layer of a conductive material having an additional inside rectangle having a smaller perimeter than the first rectangle and an additional four outside rectangles each having an incrementally greater perimeter than the perimeter of the second rectangle.

The above summary of the present invention is not intended to represent each disclosed embodiment, or every aspect, of the present invention. Other aspects and example embodiments are provided in the figure and the detailed description that follows.

The invention may be more completely understood in consideration of the following detailed description of various embodiments of the invention in connection with the accompanying drawing, in which:

While the invention is amenable to various modifications and alternative forms, specifics thereof have been shown by way of example in the drawing and will be described in detail. It should be understood, however, that the intention is not to limit the invention to the particular embodiments described but is only defined by the appended claims.

The present invention has been found to be useful reducing the noise associated with signal reflection at impedance boundaries. Through the use of meta-materials, such noise may be minimized. Meta-materials according to this invention are arrangements of conductors in an insulator to reduce the resonant response of a line as a signal propagates through it.

In an example , there is an arrangement of open planar rectangular-like shapes s of conductive material and straight lengths of conductor to match the transmission line length. A substrate has been configured as a meta-material. A pattern of conductive material (i.e., a motif) is arranged as concentric "square-circles" (hereinafter, described as rectangular-like shapes, such shapes may include but are not limited to, rectangles, squares, etc) and straight sections of metal. The signal line is a 14mm transmission line and the meta-material is designed to enhance the signal line's impedance to reduce signal noise. The sum of the lengths of the rectangular-like shapes is comparable to (and often may match) the length of the signal line. The straight sections of metal match the width of the rectangular-like shapes. The open rectangular-like shapes are square in nature with a diameter of 2.5mm, a conductor width of 0.1 mm and conductor height of 25 µm. The gaps in the rectangular-like shapes are 0.2mm. The length of signal line is 14mm, the width is 0.1mm and height is 25 µm. The insulator in this meta-material is bismaleiimide triazine (BT) resin.

The substrate may be constructed as multiple layers. Layer 1 is a ground plane of 25 µm thickness. Upon the ground plane, layer 2 is insulating material of 100µm thickness. Layer 3 is where the straight sections of metal are defined and are 25µm thickness. Layer 4 is another layer of insulating material of 100µm thickness. Layer 5 includes the arrangement of concentric rectangular-like shapes also 25µm thickness. Upon layer there is a layer of insulating material of 100µm thickness. Signal line is defined on layer 7; signal line has a thickness of 25 µm. Thus, for a given package substrate, such as used in a BGA package, the example may be implemented in four metal layers.

For a 14mm signal transmission line (Zₒ =83ohm) laid-out on BT resin insulator in the same manner but without metal rectangular-like shapes and strips a plot of the S-parameter v. Frequency was made. A square-wave input signal was driven through the signal line. A curve was obtained showing the ratio of output voltage to input voltage (e.g., the signal integrity) declining as frequency increased from 1GHz to about 30GHz. As the input frequency increased, the amplitude of the waveform decreased, indicating a reduction in output and reduction in transmission through the signal transmission line. The solution to an EM model-meshing algorithm was defined at 20GHz (which is a 7.5mm edge length) for ANSOFT proprietary software (authored by ANSOFT Corporation, Pittsburgh, PA) used in obtaining the data for the present example.

For the structure described above its S-parameter was simulated. A plot of S-parameter v. frequency showed a curve having two minima at 10GHz and 21 GHz, respectively. These two frequencies may be thought of as the resonant frequencies of the signal line on the meta-material. The 10GHz and 21 GHz are first and second harmonic frequencies, respectively. Excepting these two frequencies, the downward trend of the V_{O}/V_{IN} ratio of the above experiment was not present at other frequencies. The meta-material structure maintained the S-parameter (e.g., which is related to signal integrity) above 0.60 throughout the frequency range of 4GHz to 25GHz.

To gage the performance of a substrate configured as a meta-material with respect to a signal propagating through a metal line defined on the substrate, a test circuit is used. A goal of using the meta-material would be to match the impedance across the transmission line from the input to the output so that maximum power is transferred to the output and signal reflection within the line (at package interconnects) is minimized. From the S-parameters obtained from the above experiment, it is possible in a test circuit to show an improvement in signal quality at a number of frequencies.

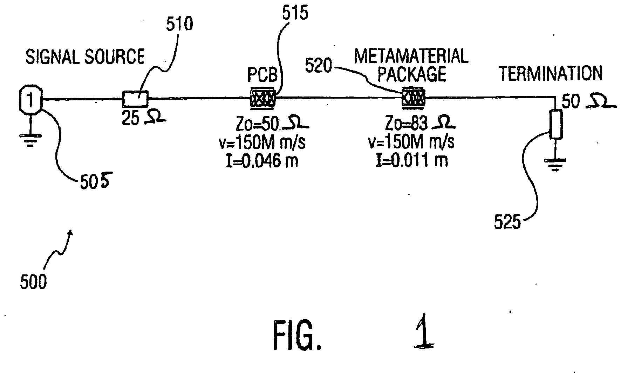

Refer to FIG.1. Test circuit 500 has a signal source 505 that provides a square -wave input to the transmission line. Coupled to the signal source 505 is load impedance 510 of about 25ohms. Coupled to the load impedance 510 is PCB material 515with a signal line having a characteristic impedance of 50 ohms (Zₒ =50ohms, υ=150M m/s, length=0.046m). Coupled to the signal line in PCB material 515 is the signal line laid-out on the meta-material package 520. This signal line for the normal transmission line case (without meta-material) has a characteristic impedance of 83ohms (Zₒ =83ohms, υ =150M m/s, length=0.011m), the impedance and length of the meta-material line having been derived from the S-parameters simulated in the above experiments. A termination 525 of 50ohms is coupled to the output of the meta-material package 520. The meta-material package 520 characteristics have been matched to those of the PCB 515 such that as the signal source 505 propagates through, noise and reflection between the PCB 515 and meta-material package 520 are minimized.

Using the circuit as depicted in FIG. 1, the meta-material package 520 undergoes testing. A plot of Vₒᵤₜ v. Time was made. At an input frequency of 400MHz, the output voltage over termination 525 is measured for both normal BT resin material and meta-material with respect to time period. The input voltage is a square wave. One curve showed the normal material and another curve shows the meta-material. There is a 100mV improvement in the Vₒᵤₜ over that for the normal material.

A further plot of Vₒᵤₜ v. Time was made. At an input frequency of 800MHz, the output voltage over termination 525 was measured for both normal BT resin material and meta-material with respect to time period. The input voltage is a square wave. One curve showed the normal material and another curve showed the meta-material. Again, there is a 100mV improvement in the Vₒᵤₜ over that for the normal material.

A still further plot 800 is Vₒᵤₜ v. Time was. At an input frequency of 2.5GHz, the output voltage over termination 525 was measured for both normal BT resin material and meta-material with respect to time period. The input voltage is a square wave. One curve showed the normal material and another curve showed the meta-material. There is about a 200mV improvement in the Vₒᵤₜ.

In an example embodiment, a meta-material is constructed in a similar pattern as described before. However, there are additional concentric squares. A substrate has a signal strip on an insulated substrate . Underneath the signal strip are seven conductive concentric squares. Each square has an opening about the center of a given side. The squares are arranged so that openings are not present on adjacent squares. Underneath the seven concentric squares , separated by insulated substrate at a pre-determined distance a straight line strip of metal runs below the areas defined by the openings and is oriented in a direction traversing the signal strip. The meta-material is disposed above a ground plane. In a high frequency structure stimulation (HFSS), the layout was analyzed in the test circuit of FIG. 1. A plot of Output Voltage v. Time was made, a curve for a 2-square substrate, a curve for a normal substrate, and a curve for a 7-square material.

In another example, the meta-material is built with a floating metal in which a pattern of concentric squares has been defined. The strips underlying the concentric squares are not present. A meta-material substrate has a signal line on insulating material. At a predetermined distance below the signal line, a floating metal having concentric squares is defined. In contrast, with the previous embodiments, the squares are regions with an absence of metal. At another predetermined distance from the floating metal is a ground plane . Such a metal substrate may be constructed in multiple layers.

The S-parameters may be plotted for such a structure. A plot of S-parameters v. Frequency was depicted. A curve having a number of minima was observed. There are minima at 7.5GHz, 19GHz, 21GHz, 25GHz, and 28GHz, respectively. These minima represent resonant frequencies and their harmonics. Having determined the S-parameters, the meta-material substrate is tested in the setup of FIG. 1.

The Vₒᵤₜ v. Time waveforms were obtained for five structures discussed supra. The improvement in Vₒᵤₜ transmission was depicted in a distinct region. A first curve depicted the results for the meta-material defined as a metal plane with square patterns within the BT material of this example. A second curve depicted the 7-metal squares an strips as presented above. A third curve depicted 2-metal square and strips. A fourth curve depicted the transmission line on normal thick BT dielectric. A fifth curve depicted the transmission line on normal thin BT dielectric.

The particular meta-material structure is determined in a given application. For example, a number of parameters, for example, are taken into account. These parameters may include, but are not limited to, 1). Length, width, thickness of signal line; 2) Number of concentric rectangular-like shapes, their dimensions; 3) the length, width thickness of straight strip line; 4) frequency range of operation; 4) distance of concentric rectangular-like shape from signal line 5) distance of straight strip line from concentric rectangular-like shapes, etc.

For a given application at a frequency of operation and line length, a number of methods for determining the desired configuration of rectangular-like shapes according to the present invention may be used.

To provide extremely accurate results would be to simulate the entire three-dimensional configuration of the meta-material structure and the effects on the signal transmission line. One method takes into account the operating frequency and physical size of the transmission line. From that information the designer would simulate a number of three-dimensional EM models to arrive at the optimal S parameter response for the application. One would vary the geometry of the rectangular-like shapes, their relative placement and their distance from the transmission line and the reference voltage plane. However, the resources and time needed to complete such a task may prove not cost-effective relative to the accuracy attained.

One method to aid in the optimization of the meta-material geometry is to think of the physical situation as a transmission line coupled to a number of tank circuits. The structure may be modelled as a series of coupled tank circuits. Each tank circuit represents the conductive line crossing over one of the six motifs of meta-material. By adjusting the electrical characteristics of the tank circuits one can achieve the desired response of the signal transmission line.

In the method, sufficient information may be obtained though it may lack the precision of three-dimensional configuration. Two-dimensional cross-sections of the rectangular- like geometry may be used to estimate the electrical characteristics of the rectangular-like shapes and their coupling to the signal transmission line. For a 60µm metal line wide metal signal line, the results of two dimensional simulations under varying spacing of the rectangular-like segments and their distance from the signal line and voltage reference plane (commonly defined as ground, at 0v) were obtained.

The system and software used to simulate the structure and resulting plots was an ANSOFT 2D Extractor (two-dimensional EM simulator).

A two-dimensional structure was simulated. Metallization having three conductive strips is separated at a vertical distance B from a voltage reference plane. The three conductive strips are separated at a horizontal distance s from one another. A signal line is separated a vertical distance T from the metallization. The signal line and three conductive strips are at a fixed width W. In an example , the dimensions B, S, and T range from about 60µm to about 100µm. The width W of the signal line and the three conductive strips is fixed at about 60µm. The tank circuit depicts a circuit model of the two-dimensional structure.

Thus, for a given signal transmission line, in the coupled tank circuits one can refer to the plots of the signal line inductance (Lₛ), signal line capacitance to metallization (Cₛₘ), signal line capacitance to ground (C_{gm}), signal line mutual inductance to metallization (Lₖₘ), and metallization inductance (Lₘ). Therefore, the coupled tank LC values are adjusted to optimize the signal through the transmission line. A plot of unit capacitance (F/m) C_{sg} v. Metallization Spacing (s) at a variety of vertical distances b and t was obtained. A plot of unit capacitance (F/m) Cₛₘ v. Metallization spacing was obtained. A plot of unit inductance (H/m) Ls v. Metallization Spacing was obtained. A plot of unit inductance (H/m) Lₖₛₘ v. Metallization was obtained. A plot of unit inductance (F/m) Lₘ v. Metallization Spacing was obtained. These components Cₛ, C_{sg}, Lₛ, Lₖₛₘ, and Lₘ are part of the tank circuit.

It is possible to utilize the five plots in deriving appropriate unit capacitance and unit inductance values for a given layout of a signal transmission line and meta-material arranged according to an embodiment of the present invention. In an example design, the user is configuring a signal transmission line on a meta-substrate. The horizontal distance S for the metallization spacing s is defmed at about 80µm, the vertical distance T of the signal transmission line to the metallization is defined at 80µm and the vertical distance B of the metallization to the voltage reference plane is defined at 80µm, and the width W of the signal transmission line is about 60µm. Within these predetermined parameters, the unit inductance and unit capacitance values may be read from the plots. These values provide a first order approximation providing a starting point to iterate to a more accurate solution. Table 1 depicts lists of the values obtained. These values of capacitance and inductance are those that optimize signal transfer through the signal line, given the dimensions S, B, T, and W of the two-dimensional structure.

| **Table 1. Value of Capacitance/Inductance for Two-Dimensional Model** | | | | | | | |
|---|---|---|---|---|---|---|---|
| **Sµm** | **B (µm)** | **T(µm)** | **C_{sg}(F/m)** | **Cₛₘ(F/m)** | **Lₛ(H/m)** | **Lₖₛₘ(H/m)** | **Lₘ(H/m)** |
| 100 | 100 | 100 | (AA) 2.16 x 10⁻¹¹ | (CC) 9x10⁻¹¹ | (DD) 6.30 x 10⁻⁷ | (FF) 2.17 x 10⁻⁷ | (HH) 5.30 x 10⁻⁷ |
| 100 | 80 | 80 | (BB) 2.08 x 10⁻¹¹ | (CC) 1.9 x 10⁻¹¹ | (FF) 595 x 10⁻⁷ | (GG) 1.96 x 10⁻⁷ | (JJ) 4.96 x 10⁻⁷ |

Likewise, it can be determined if the designer desires specific capacitance and inductance values (as present in the tank circuit), the plots may be used to fmd the dimensions of S, B, T, and W. The technique described may be programmed into a computer to calculate a range of dimensions and capacitance/inductance values. With a sufficient number of data points gathered, one may develop a series of equations to model the desired characteristics were generated at an input frequency of 1 GHz.

As a result of designing the meta-material, one can observe plots of the ε_{R} and µ_{R} in a range of input frequencies. For a limited range of input frequency, the real component of the permeability µ_{R} may be observed going negative (µ_{R} <0). At a resonant frequency, the plots exhibit peaks.

For the control material of a signal line on BT substrate, the permittivity and permeability were plotted over frequency. The permittivity and permeability have a real component and an imaginary component. The real components of ε_{R} and µ_{R} did not go negative. At the resonant frequency, peaks in the curves were observed.

The real component of permeability of the signal line on meta-material goes negative in the frequency range of about 2.50GHz to about 3.50GHz. At resonant frequencies, peaks were noted in the curves of the component parts of ε_{R} and µ_{R} Consequently, the effect of the meta-material provides for enhanced signal transfer and maintenance of more constant impedance over a useable frequency range. The performance of IC devices is therefore, enhanced.

While the present invention has been described with reference to several particular example embodiments, those skilled in the art will recognize that many changes may be made thereto without departing from the scope of the following claims.

## Claims

1. A substrate having a topside surface, a signal line of pre-determined dimensions defined on the topside surface and an underside surface, the substrate configured as a meta-material, the meta-material providing noise protection for the signal line , the substrate comprising:
a conductive ground plane defining the underside surface of the substrate;
a layer of a conductive material configured into two concentric rectangles, each rectangle having a notch defined on a side about a midpoint and the notch in a first rectangle is opposite the notch in a second rectangle, the first rectangle having a smaller perimeter than the second rectangle, and the layer of conductive material disposed above the conductive ground plane at a first pre-determined distance and the layer of the conductive material disposed at a second pre-determined distance below the signal line defined on the topside surface of the substrate;
a dielectric material enveloping the layer of the conductive material, the dielectric material bounded between the topside surface and underside surface of the substrate; and
the collective dimensions of the concentric rectangles are comparable to the pre-determined dimensions of the signal line, **characterized in that** the layer of a conductive material includes an additional inside rectangle having a smaller perimeter than the first rectangle and an additional four outside rectangles each having an incrementally greater perimeter than the perimeter of the second rectangle.

2. The substrate as recited in claim 1 wherein the concentric rectangles are squares.

3. The substrate as recited in claims 2, wherein the layer of a conductive material consists of a metallization sheet, the metallization sheet being configured into rectangles wherein conductive material is absent.

4. The substrate as recited in claim 1, wherein a strip line having a length comparable to the length of the additional fourth outside rectangle, is situated between the conductive layer and the conductive ground plane, the strip line near the conductive layer, the strip line running underneath the notch of each rectangle, the strip line having a width comparable to a width of the notoh of each rectangle.

## Patentansprüche

1. Substrat, das eine Oberseite, eine Signalleitung vorbestimmter Abmessungen, die auf der Oberseite ausgebildet ist, und eine Unterseite hat, wobei das Substrat als ein Meta-Material konfiguriert ist und das Meta-Material einen Rauschschutz für die Signalleitung bietet, wobei das Substrat enthält:
eine leitfähige Erdungsfläche, die die Unterseite des Substrates bildet;
eine Schicht eines leitfähigen Materials, das in Gestalt von zwei konzentrischen Rechtecken ausgebildet ist, wobei jedes Rechteck eine Kerbe hat, die auf einer Seite um einen Mittelpunkt ausgebildet ist, und die Kerbe in einem ersten Rechteck der Kerbe in dem zweiten Rechteck gegenüberliegt, wobei das erste Rechteck einen geringeren Umfang hat als das zweite Rechteck und die Schicht des leitfähigen Materials über der leitfähigen Erdungsfläche in einem ersten vorbestimmten Abstand angeordnet ist und die Schicht des leitfähigen Materials in einem zweiten vorbestimmten Abstand unter der Signalleitung angeordnet ist, die auf der Oberseite des Substrates ausgebildet ist;
ein dielektrisches Material, das die Schicht des leitfähigen Materials umhüllt, wobei das dielektrische Material zwischen der Oberseite und der Unterseite des Substrates begrenzt ist, und
die Gesamtabmessungen der konzentrischen Rechtecke mit den vorbestimmten Abmessungen der Signalleitung vergleichbar sind, **dadurch gekennzeichnet, dass**
die Schicht eines leitfähigen Materials ein zusätzliches inneres Rechteck, das einen geringeren Umfang als das erste Rechteck hat, und vier zusätzliche äußere Rechtecke enthält, die jeweils einen inkrementell größeren Umfang haben, als der Umfang des zweiten Rechteckes.

2. Substrat nach Anspruch 1, bei dem die konzentrischen Rechtecke Quadrate sind.

3. Substrat nach Anspruch 2, bei dem die Schicht eines leitfähigen Materials aus einer Metallisierungsfolie besteht, wobei die Metallisierungsfolie zu Rechtecken ausgebildet ist, in denen kein leitfähiges Material vorhanden ist.

4. Substrat nach Anspruch 1, bei dem sich eine Streifenleitung, die eine Länge hat, die mit der Länge des zusätzlichen vierten äußeren Rechteckes vergleichbar ist, zwischen der leitfähigen Schicht und der leitfähigen Erdungsfläche befindet, sich die Streifenleitung in der Nähe der leitfähigen Schicht befindet, die Streifenleitung unter der Kerbe jedes Rechteckes verläuft und die Streifenleitung eine Breite hat, die mit einer Breite der Kerbe jedes Rechtecks vergleichbar ist.

## Revendications

1. Substrat comportant une surface supérieure, une ligne de signal de dimensions prédéterminées définie sur la surface supérieure, et une surface inférieure, le substrat étant configuré en tant que métamatériau, le métamatériau offrant une protection contre le bruit pour la ligne de signal, le substrat comprenant :
un plan de masse conducteur définissant la surface inférieure du substrat ;
une couche d'un matériau conducteur configurée en deux rectangles concentriques, chaque rectangle comportant une encoche définie sur un côté autour d'un point central et l'encoche d'un premier rectangle est opposée à l'encoche d'un deuxième second rectangle, le premier rectangle ayant un périmètre plus petit que celui du deuxième rectangle, et la couche de matériau conducteur disposée au-dessus du plan de masse conducteur à une première distance prédéterminée et la couche du matériau conducteur disposée à une seconde distance prédéfinie sous la ligne de signal étant définies sur la surface supérieure du substrat ;
un matériau diélectrique enveloppant la couche du matériau conducteur, le matériau diélectrique étant coincé entre la surface supérieure et la surface inférieure du substrat ; et
les dimensions collectives des rectangles concentriques sont comparables aux dimensions prédéterminées de la ligne de signal, **caractérisé en ce que**
la couche d'un matériau conducteur comprend un rectangle intérieur supplémentaire ayant un périmètre plus petit que celui du premier rectangle et des quatrièmes rectangles extérieurs supplémentaires ayant chacun un périmètre incrémentiellement plus grand que le périmètre du deuxième rectangle.

2. Substrat selon la revendication 1, dans lequel les rectangles concentriques sont carrés.

3. Substrat selon la revendication 2, dans lequel la couche d'un matériau conducteur se compose d'une feuille de métallisation, la feuille de métallisation étant configurée en rectangles, dans lesquels le matériau conducteur est absent.

4. Substrat selon la revendication 1, dans lequel une ligne à ruban, ayant une longueur comparable à la longueur du quatrième rectangle extérieur supplémentaire, se situe entre la couche conductrice et le plan de masse conducteur, la ligne à ruban étant proche de la couche conductrice, la ligne à ruban passant sous l'encoche de chaque rectangle, la ligne à ruban ayant une largeur comparable à une largeur de l'encoche de chaque rectangle.
